# EUROPÄISCHE PATENTANMELDUNG

(11) **EP 1 251 228 A2**
(43) Veröffentlichungstag der Anmeldung: **23.10.2002**
(21) Anmeldenummer: 02002493.1
(22) Anmeldetag: 02.02.2002
(51) Int. Cl.: E05F 15/20, G01B 7/00

(54) **Induktiver Sicherheitssensor zur Überwachung von Türen und Toren**

(30) Priorität: 23.03.2001 DE 20105164 U
(71) Anmelder: Bernstein AG, 32457 Porta Westfalica (DE)
(72) Erfinder: Hofmann, Andreas, Dipl.-Ing., 32257 Bünde (DE); Krühler, Matthias, Dipl.-Ing., 31675 Bückeburg (DE)
(74) Vertreter: Specht, Peter, Dipl.-Phys.

(57) **Zusammenfassung**

Induktiver Sicherheitssensor zur Überwachung des Zustandes von Türen und Toren, insbesondere von Aufzügen, mit einer Sensoreinrichtung zur Sensierung eines Targets, die derart ausgelegt ist, daß sie nur bei einer Sensierung eines Targets aus einem vorgegebenen Materials ein Signal abgibt und von einem ersten Konstantstrom auf einen anderen Konstantstrom umschaltet.

## Beschreibung

Die Erfindung betrifft einen induktiven Sicherheitssensor zur Überwachung des Zustandes von Türen und Toren, insbesondere von Aufzügen und/oder Liften.

Zweikanalig aufgebaute Induktive - Sicherheitssensoren werden zur Überwachung von elektrisch und mechanisch bewegten Drehtüren, Schiebetüren, Rolltore, Klappen und Luken eingesetzt. Sicherheitssensoren gewährleisten eine sichere Überwachung der Offen- bzw. Schließstellung von Türen und Toren. Während sich handelsübliche induktive Näherungsschalter mit praktisch allen metallischen Gegenständen betätigen lassen, setzt die Erfindung bei der Idee an, den Näherungsschalter derart auszugestalten, daß er nur durch ein speziell ausgeführtes Betätigungselement ein Signal abgibt. Die Schaffung eines derartigen induktiven Näherungssensors mit einem konstruktiv einfachen Aufbau ist die Aufgabe der Erfindung.

Die Erfindung löst diese Aufgabe durch den Gegenstand des Anspruches 1.

Danach weist der Sicherheitssensor zur Überwachung des Zustandes von Türen und Toren, insbesondere von Aufzügen, eine Sensoreinrichtung zur Sensierung eines Targets auf, die derart ausgelegt ist, daß sie nur bei einer Sensierung eines Targets aus einem vorgegebenen Materials ein Signal abgibt und von einem ersten Konstantstrom auf einen anderen Konstantstrom umschaltet.

Gegenüber den bisher eingesetzten einkanaligen mechanischen Sicherheitsschaltern haben die erfindungsgemäßen Sicherheitssensoren insbesondere folgende Vorteile:
- Sensor und Target arbeiten berührungslos;
- kein mechanischer Verschleiß durch Reibung oder Abbrand an den Kontakten;
- Sensor und Target sind zweikanalig aufbaubar;
- Sensor und Target sind aufeinander abstimmbar. Durch geeignete Maßnahmen kann sichergestellt werden, dass eine Manipulation durch fremde Targets (Nicht-Ferrite) ausgeschlossen ist. Eine Manipulation durch Magnete, Drahtbrücken und Ähnliche Materialien ist daher nicht möglich. Interne Signalauswertung über störfeste Phasendemodulation.
- Die Schutzart IP67 ist realisierbar.
- Es können mehrere Schaltpunke sicher Überwacht werden
- Veränderungen des Abstandes zwischen Sensor und Target durch Materialermüdung werden erkannt und über das Sicherheits-Bussystem an z.B. eine Kontrolleinheit gemeldet (vorbeugende Wartung).
- Durch die Anbindung an ein Sicherheits-Bussystem, z.B. an das der Anmelderin, (CAN-OPEN-SAFETY) werden die Ausgangssignale Redundant überwacht. Signalübertragung zum Bus-Knoten über störfeste Stromschleifen.
- Die Befestigung des Sicherheitssensors kann auf einfache Weise durch Gewindebolzen oder Innengewinde erfolgen.
- Nach einer Variante ist ein Abgleich der Betriebsdaten des Sensors (Schaltabstand) über eine vorteilhaft unkomplizierte Konstruktion der Sensorspule realisierbar.

Die Sensoren reagieren nach einer Ausführungsform nur auf Ferrit und schalten bei einer Detektion von einem Konstantstrom auf einen anderen Konstantstrom um. Dies soll eine Leitungsüberwachung möglich machen, da andere Betriebsströme als jene definierten auf eine Kabelstörung schließen lassen.

Aus sicherheitstechnischen Gründen wird der Sensor redundant aufgebaut, d. h. jedes Sensorgehäuse beinhaltet zwei Sensorsysteme, die bis auf die positive Versorgungsspannung völlig voneinander getrennt sind. Beide Systeme sind identisch bis auf die Erregerfrequenz, die gering unterschiedlich sein muss, um eine gegenseitige Beeinflussung zu verhindern. Im weiteren Verlauf wird deshalb immer nur ein System betrachtet.

Nachfolgend werden Ausführungsbeispiele unter Bezug auf die Zeichnung näher beschrieben. Es zeigt:
- Fig. 1: ein Blockschaltbild eines erfindungsgemäßen induktiven Sensors;
- Fig. 2: einen Oszillator 1 für einen erfindungsgemäßen induktiven Sensor;

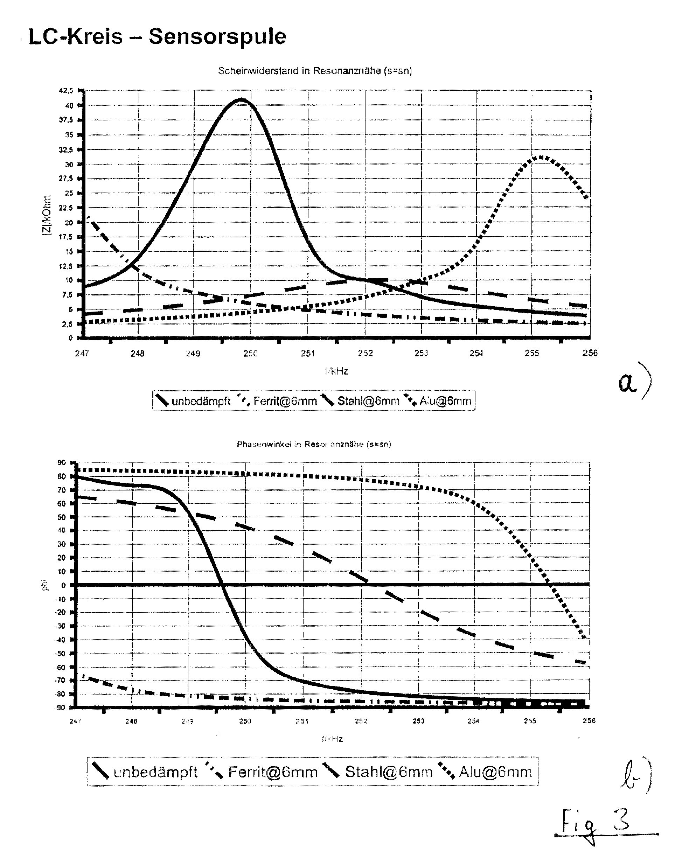

- Fig. 3a und 3b: Diagramme, welche das Verhalten des Scheinwiderstandes bei Einsatz verschiedener Targets in Resonanznähe wiedergeben;

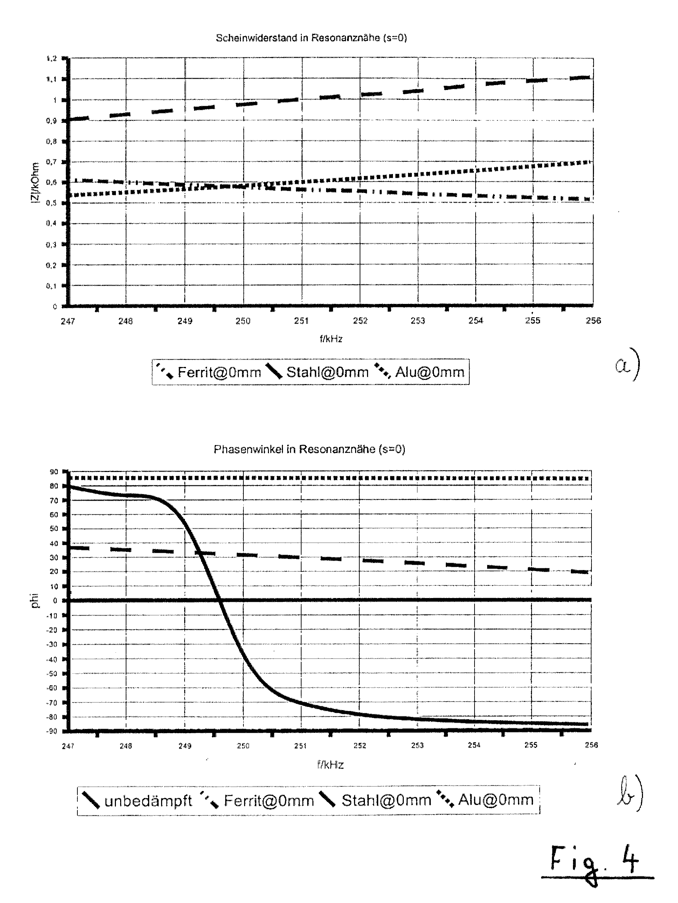

- Fig. 4b und 4b: Diagramme, welche das Verhalten des Phasenwinkels bei Einsatz verschiedener Targets in Resonanznähe wiedergeben;
- Fig. 5: Darstellungen des konstruktiven Aufbaus einer Spule für den erfindungsgemäßen Sensor;
- Fig. 6: ein Schaltbild eines Null-Spannungsdetektors für einen erfindungsgemäßen Sensor;
- Fig. 7a: ein Schaltbild eines Phasenkomparators für einen erfindungsgemäßen Sensor;
- Fig. 7b: eine Wahrheitstabelle für einen Phasenkomparator;
- Fig. 7c: verschiedene Phasendiagramme;
- Fig. 8: ein Schaltbild eines Schwellwertschalters für einen erfindungsgemäßen Sensor; und
- Fig. 9: ein Schaltbild eines Längsreglers für einen erfindungsgemäßen Sensor.

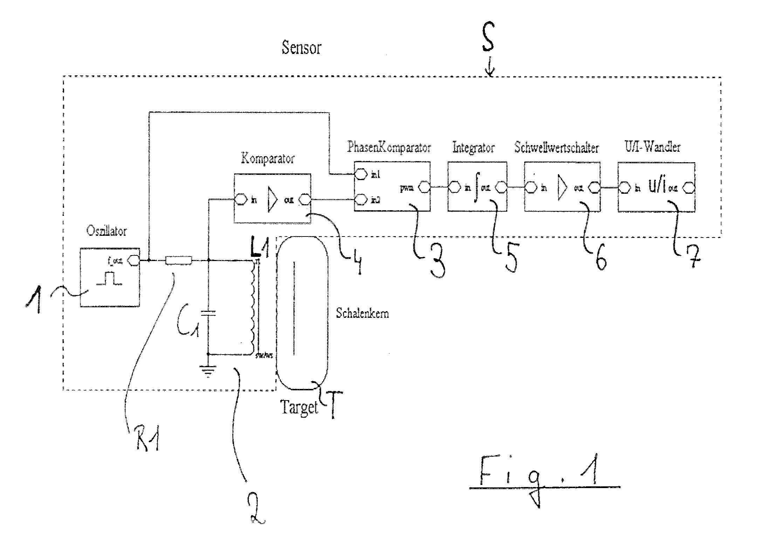

Zunächst sei das Blockschaltbild des Sensors S mit Target T nach Fig. 1 beschrieben.

Ein Sensor S wird beispielsweise in einem Teil einer (hier nicht dargestellten) Tür angeordnet und das Target - falls überwacht werden soll, ob die Tür offen oder zu ist in einem relativ zum ersten Teil beweglichen zweiten Teil der Tür. Der Aufbau dieses Sensors S ist wie folgt.

Ein Oszillator 1 generiert eine quarzgenaue Rechteckschwingung, die zwei weiteren Baugruppen zugeführt wird. Einmal gelangt das Signal über einen Widerstand R1 zu einem Schwingkreis 2 aus C1 und L1, welcher die Aufgabe hat, auf Feldveränderungen durch äußere Gegenstände zu reagieren. Zum anderen wird das Signal aus dem Oszillator 1 einem Phasenkomparator 3 zugeführt, welcher die Phasenlage dieses Signals mit der Phasenlage des Schwingkreises 2 vergleicht.

Da der Phasenkomparator 3 nur digitale Signale verarbeitet, wird die Sinusschwingung des LC-Kreises 2 vorher einem Nullspannungsdetektor (Komparator ) 4 zugeführt, der die Sinusschwingung in ein Rechtecksignal umwandelt. Der Phasenkomparator 3 ist so ausgelegt, dass er nur auf negative Phasenwinkel reagiert. Hinter dem Phasenkomparator 3 entsteht ein PWM-Signal, dessen Puls-Pause-Verhältnis ein Maß für die Veränderung des LC-Kreises ist.

Über einen Integrator 5 wird das PWM-Signal in eine dem Puls-Pause-Verhältnis folgende Gleichspannung transformiert und einem Schwellwertschalter 6 zugeführt, der so dimensioniert ist, daß nur die Veränderung des Schwingkreises, die durch ein spezielles Material (Ferrit) in einem genau definiertem Abstand hervorgerufen wird, zu einem Schalten dieses Schalters führt. Durch diese Vorgang wird dem Betriebsstrom über einen dazugeschalteten Widerstand ein weiterer Strom hinzugeschaltet. Da die gesamte Schaltung über einen Längsregler 7 auf konstanter Spannung gehalten wird, ist somit aus dem Spannungswechsel hinter dem Schwellwertschalter 6 ein Stromwechsel (U/I-Wandlung) geworden.

Die weiteren Figuren zeigen u.a. weitere Einzelheiten der vorstehend erläuterten Bestandteile des erfindungsgemäßen Sensors. Die einzelnen Schaltungsteile werden unter Bezug auf die weiteren Fig. näher erläutert.

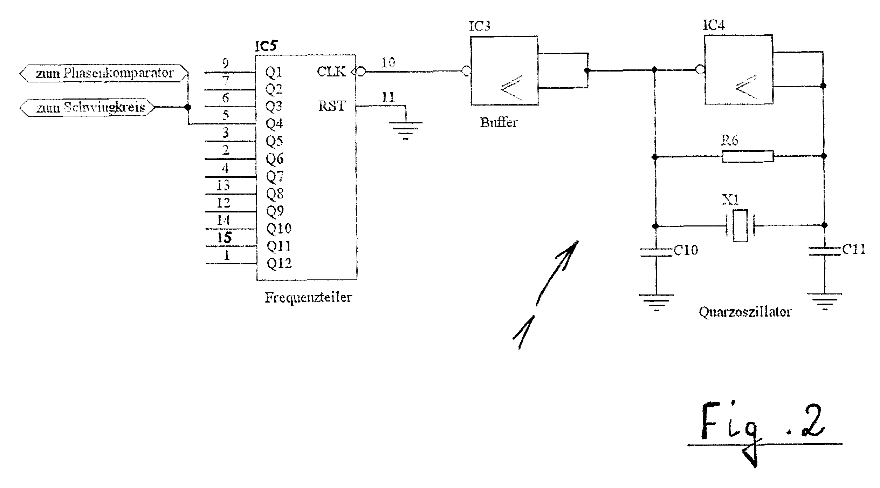

Fig. 2 zeigt den näheren Aufbau des Oszillators 1. Mit den Bauteilen IC3, IC4, IC5, X1, C10, C11 und R6 wird ein genauer Oszillator 1 realisiert. Die Kombination mit dem Frequenzteiler hat zum einen Kostengründe, da somit sehr billige Quarze im Megahertz-Bereich verwendet werden können, zum anderen bietet es ein Höchstmaß an Flexibilität hinsichtlich der Frequenzauswahl. Ein letzter Grund ist die absolute Symmetrie (Puls-Pause-Verhältnis = 1) des Rechtecksignals. Da die Eingänge des Frequenzteilers HC4040 flankengetriggert sind, wird des Signal von IC4 mit dem Gatter IC3 gepuffert.

Gemäß Fig. 1 wird die Rechteckschwingung über den Widerstand R1 dem Schwingkreis 2 mit den Kondensatoren C1 und der Spule L1 zugeführt. Die Größe des Widerstandes R1 liegt in der Größenordnung des Wirkwiderstandes des LC-Kreises bei Resonanz.

Die grobe Lage der Erregerfrequenz richtet sich nach der Größe der Ferritspule bzw. dem Gütemaximum (Kenngröße der Ferritspule, unabhängig von der Resonanz des LC-Kreises) dieser Spule, um eine maximale Empfindlichkeit zu erreichen.

Die Lage der Erregerfrequenz zur Resonanzfrequenz bestimmt maßgeblich das Verhalten des Sensors auf die unterschiedlichen Materialien (Targets). Prinzipiell lassen sich mehrere unterschiedliche Detektionsverhalten erzielen. Um anforderungsgemäß Ferrit von anderen Materialien zu unterscheiden, muss eine Erregerfrequenz gewählt werden, bei der sich für alle Annäherungsabstände für eben dieses Material Phasenwinkel einstellen, die in keiner anderen Bedämpfungssituation erzielt werden. Die exakte Lage dieses Punktes läßt sich ermitteln, indem man über der Frequenz Scheinwiderstände |Z| und Phasenwinkel Phi bei verschiedenen Bedämpfungsmaterialien (Ferrit, Eisen, Buntmetalle) mit unterschiedlichen Abständen (0 <s < sn) mißt.

Der anschließende Phasenkomparator 3 ist so ausgelegt, dass er nur auf negative Phasenwinkel, die durch Materialien mit einer hohen magnetischen Permeabilität hervorgerufen werden, reagieren kann. Sinnvollerweise wird die die Resonanzfrequenz des LC-Kreises 2 so ausgelegt, dass die Erregerfrequenz auf der abfallenden Flanke der Resonanzkurve liegt. Hier zeigt der Sensor die größte Empfindlichkeit. Diese beiden Frequenzwerte unterscheiden sich aufgrund der sehr schmalen Bandbreite des LC-Kreises nur um einige Hertz. Folglich muss der Schwingkreis 2 abgeglichen werden, da die präzise Lage der Resonanz nicht mit den üblichen Bauteiltoleranzen zu erreichen ist.

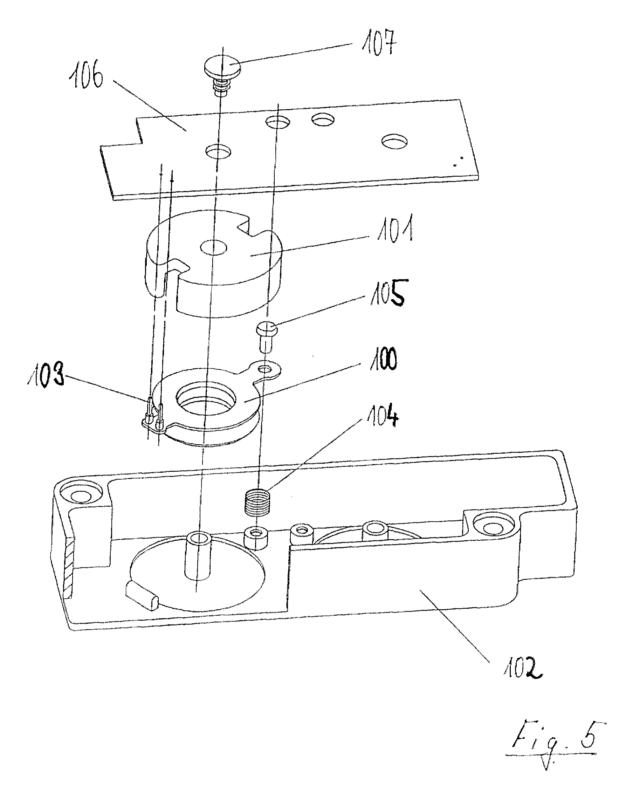

Weiterhin ergibt sich hieraus die Forderung, den LC-Kreis 2 als solchen abzugleichen. Dieses führte zu der Konstruktion abgleichbarer Spulen nach Fig. 5.

Abweichend von den herkömmlichen Spulen für Näherungsschalter wurde in dieser Konstruktion der Wickelkörper 100 etwas flacher ausgelegt und über eine Verstellmechanik in der Lage verstellbar. Die Wickelkörper 100 sind in ein Gehäuse 102 eingesetzt. Sie weisen Lötstifte 103 auf und sind über die Feder 104 und die Schraube 105 verstellbar. Schalenkern 101, Leiterplatte 106 sowie der Wickelkörper 100 werden durch einen Fixierstift 107 am Gehäuse festgelegt.

Dadurch sind Induktivitätsänderungen von 10% erreichbar, die ausreichend sind, die zu erwartenden Toleranzen in der Wicklung und im Kernmaterial auszugleichen. Der Abgleich geht dann wie folgt vonstatten: Der Sensor wird mit einem Target im Nennschaltabstand bedämpft. Der Wickelkörper 100 wird nun solange verstellt, bis sich das Ausgangssignal ändert (schaltet). Nach der Justage wird der komplette Sensor mit Epoxidharz vergossen, um eine dauerhafte Stabilität und Resistenz gegenüber Umwelteinflüssen zu gewährleisten.

Definitionsgemäß soll der Sensor nur auf ein bestimmtes Gegenstück reagieren. Dieses ist natürlich in einem getrennten Gehäuse untergebracht und besteht aus elektronischer Sicht lediglich aus zwei Schalenkernen der gleichen Bauart, wie sie im Sensor verwendet werden. Bei den definierten Einbaubedingungen liegen sich die Schalenkernhälften paarweise gegenüber. Der Feldlinienweg des LC-Kreises wird nun drastisch verringert, was zu einer Erhöhung der Induktivität und in Folge dessen zu einer Erniedrigung der Resonanzfrequenz führt

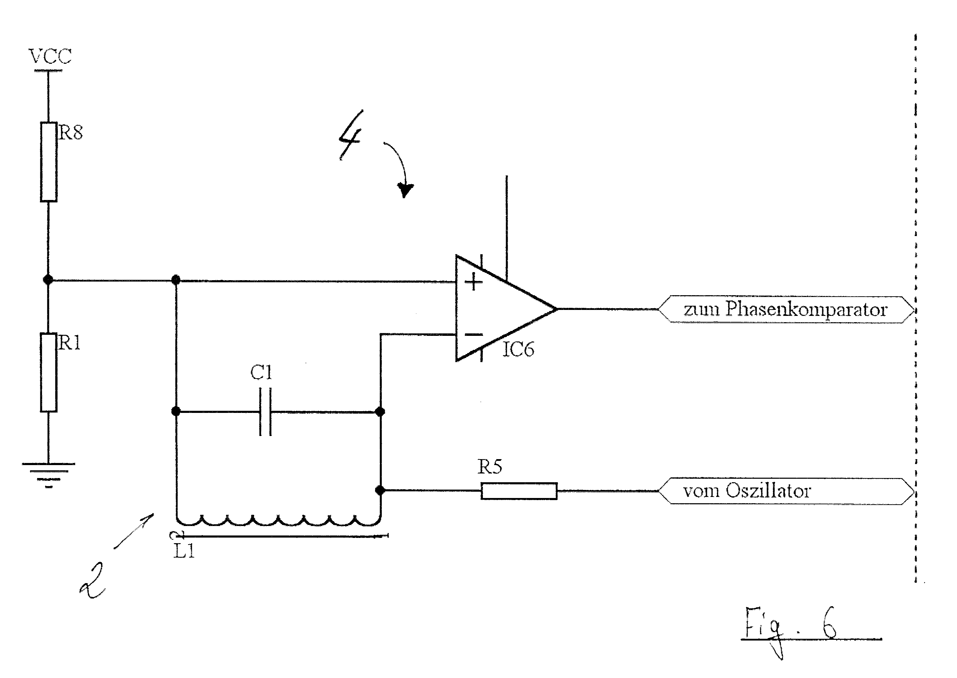

Nachfolgend sei anhand der Fig. 6 der Null-Spannungsdetektor (Komparator 4) beschrieben. Der Fußpunkt des LC-Kreises aus C1 und L1 liegt auf halber Betriebsspannung. Dieser Punkt liegt auch auf dem nicht-invertierenden Eingang des Komparators 4 (IC6). Erzeugt wird diese Spannung mit den in Reihe zwischen Erde und Vcc geschalteten Widerständen R1, R8.

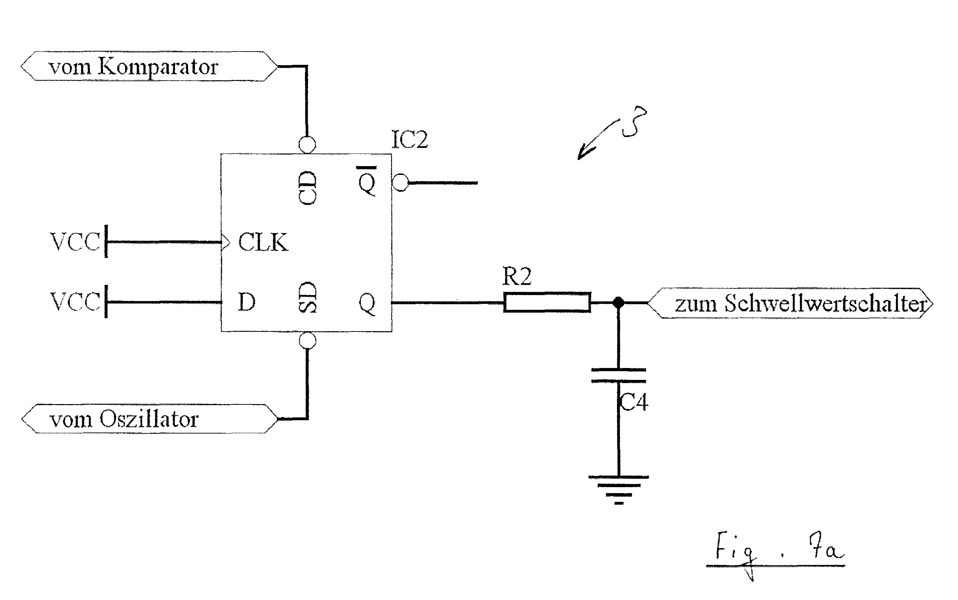

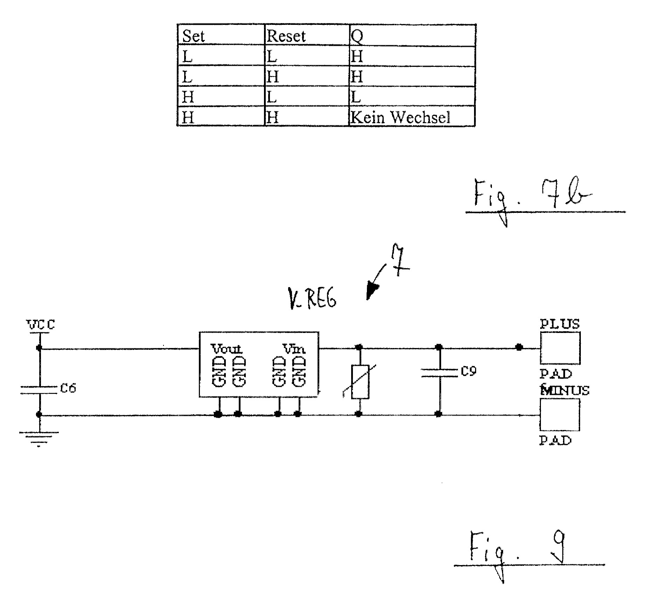

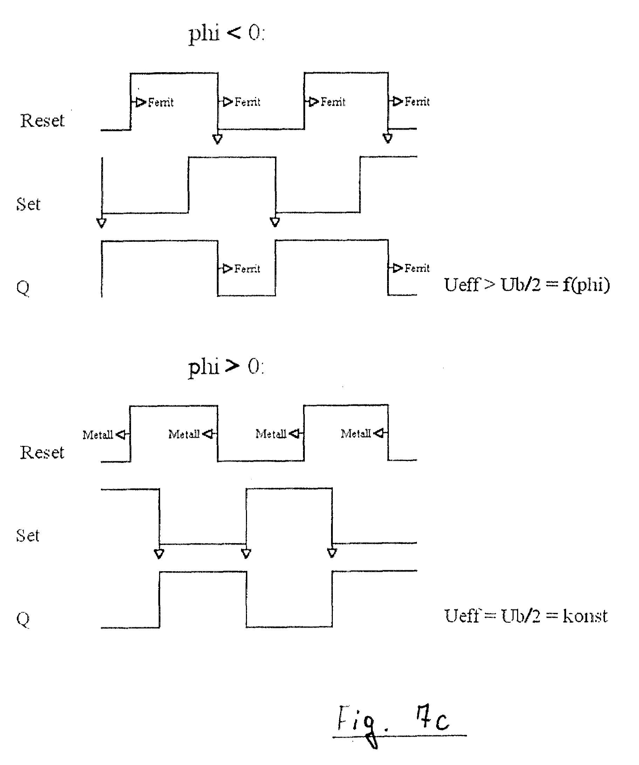

In Hinsicht auf den Phasenkomparator 3 der Fig. 7a sei angemerkt, daß üblicherweise zur Phasendetektion EXOR-Gatter verwendet werden. Auch die grundlegende Schaltungsapplikation verwendet diese Möglichkeit, die in dieser Anwendung jedoch Schwierigkeiten bereiten würde, da sie Phasenwinkel hinsichtlich des Vorzeichens nicht unterscheiden kann.

Wird statt des EXOR-Gatters ein D-Flip-Flop in geeigneter Anordnung benutzt, ist es möglich, die Reaktion auf die unerwünschten positiven Phasenwinkel völlig auszublenden. Unter der Voraussetzung, dass die Clock- und Data-Eingänge des D-Flip-Flops ständig auf High-Potential liegen, läßt sich die Wahrheitstabelle vereinfacht so darstellen:

| | | |
|---|---|---|
| Set | Reset | Q |
| L | L | H |
| L | H | H |
| H | L | L |
| H | H | Kein Wechsel |

Aus den Impulsdiagrammen (Fig. 7c) ist nun ersichtlich, dass nur negative Phasenwinkel eine Änderung des Puls-Pause-Verhältnisses hervorrufen.

Mit R2 und C4 wird das PWM-Signal integriert. Mit einer Zeitkonstante von ca. 1ms liegt man einerseits weit überhalb der Periodendauer des Oszillators, andererseits ist sie noch schnell genug, um die erforderliche Schaltfrequenz zu erreichen. Proportional zum Phasenwinkel liegt an diesem Punkt eine Gleichspannung an, die zwischen 2,5V (entspricht 0°) und 5V (entspricht -90°) variieren kann.

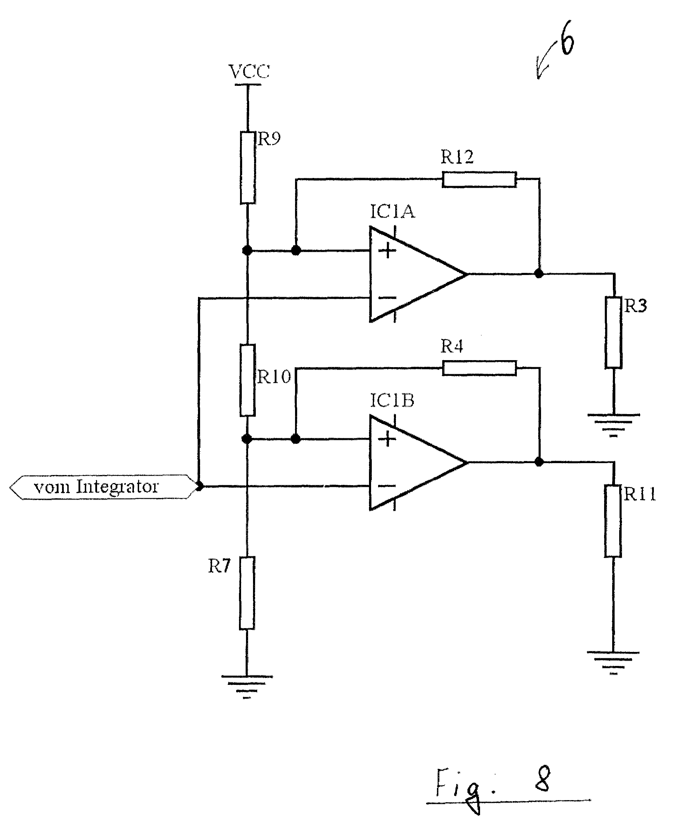

Mit dem Schwellwertschalter 6 der Fig. 8 wird folgendes erreicht. Mit den beiden Komparatoren des IC1 werden nun zusätzlich zum Betriebsstrom, der nahezu konstant ist, zwei weitere Ströme dazugeschaltet. Ein Strom wird bei Erreichen des Nennschaltabstands, ein zweiter Strom bei Erreichen eines etwas geringeren Diagnose-Schaltabstandes (yellow-state) dazugeschaltet. Dieser zweite Schaltabstand kann benutzt werden, um einen mechanische Verschleiß der Anlage zu erkennen. Die Schwelle des Nennschaltabstands resultiert direkt aus der Phasenlage bzw. des Frequenzabstands, der zur Erkennung des Ferrits nötig ist. Sie wird mit R7 und R9/R10 festgelegt. Mit R4 bzw. R12 werden Schalt-Hysteresen erzeugt.

Der Längsregler 7 V_REG der Fig. 9 sorgt für eine konstante Betriebsspannung des Sensors. Die gesamte Sensorschaltung arbeitet komplett mit relativen Pegeln und würde deshalb in weiten Bereichen ohne eine solche präzise Spannungregelung auskommen können. Mit der Konstantspannung werden jedoch konstante Ströme erzeugt, die von der Eingangsspannung unabhängig sind. Somit ist mit dieser Schaltungsanordnung eine steuerbare Stromquelle realisiert.

### Schachttür- und Kabinentürüberwachung

Die Sicherheits-Türschalter werden z.B. an einer Aufzugs Schachttür und Fahrkorbtür zur Überwachung der Verriegelung und der Schließstellung eingebaut.

Im Normalbetrieb darf es nicht möglich sein, eine Schachttür zu öffnen, wenn der Fahrkorb nicht hinter dieser Tür steht, oder sich innerhalb der Entriegelungszone befindet. Die Sicherheits-Türschalter werden z.B. bei gemeinsam mit der Fahrkorbtür angetriebenen kraftbetätigten Schachttüren eingesetzt.

Die Montage des Sicherheits-Türschalters an der Schachttür erfolgt gem. EN81 7.7.3.1. Bei dieser Anwendung wird das mechanische Verriegelungselement durch den Sicherheits-Türschalter überwacht. Die wirksame Verriegelung der geschlossenen Schachttür muss der Bewegung des Fahrkorbes vorausgehen. Der Fahrkorb darf erst anfahren , wenn das Sperrmittel mindestens 7mm eingegriffen hat. Der S-T überwacht Zweikanalig die Lage des Sperrmittels. Die geforderte Redundanz wird durch dem Sensorknoten sichergestellt. Der Sensorknoten meldet die Lage des Sperrmittels an den Bus Master.

### Schließstellung

Die Sicherheits-Türschalter werden zur Überwachung der Schließstellung gem. EN 81 7.7.4.1, 7.7.6.2 und 8.9.2 eingesetzt.

Gemäß EN 81 darf der Spalt zwischen den Türblättern nicht größer als 10 mm sein. Ist der Abstand zwischen den Türblättern größer als 10 mm muss die Aufzugsanlage in einen sicheren Zustand gebracht werden. Sollte der Spalt z.B. größer als 7 mm sein, wird dieser Zustand vom Sicherheits-Türschalter erkannt und über den Sicherheitsbus eine zusätzliche Information zum Nachstellen der Tür gegeben werden.

Durch die Verknüpfung der Fahrkorbtür- und Schachttürsignale kann z.B. erkannt werden, dass beim Öffnen der Schachttür (mittels Notentriegelung), die Fahrkorbtür bzw. Fahrkorb nicht hinter der Schachttür ist. Durch diese Auswertung wird die Aufzugsanlage in einen sicheren Zustand gebracht.

Öffnet ein Monteur in der untersten Haltestelle die Schachttür, um Wartungsarbeiten in der Schachtgrube durchzuführen, sollte er den Notbremsschalter zu seiner Sicherheit betätigen. Sollte die Schachtür zulaufen bevor der Notbremsschalter betätigt wurde kann die Aufzugsanlage bei vorliegen eines Außenrufes starten.

Durch die Auswertung des Schachttür- und Kabinentürsignale wird erkannt das eine Manipulation vorliegt (Schachttür war offen, Kabinentür geschlossen).
Bei vorliegen dieser Kombination wird ein anlaufen der Aufzugsanlage durch die Auswertung der Signale in der Steuerung verhindert.

Durch diese Kombination ist auch sichergestellt dass, das Surfen auf dem Kabinendach durch Manipulation der Türschalter nicht möglich ist.

Bei mechanischen Türschaltern sind solche logische Verknüpfungen von Signalen nicht möglich.

## Patentansprüche

1. Induktiver Sicherheitssensor zur Überwachung des Zustandes von Türen und Toren, insbesondere von Aufzügen, mit einer Sensoreinrichtung zur Sensierung eines Targets, die derart ausgelegt ist, daß sie nur bei einer Sensierung eines Targets aus einem vorgegebenen Materials ein Signal abgibt und von einem ersten Konstantstrom auf einen anderen Konstantstrom umschaltet.

2. Induktiver Sicherheitssensor nach Anspruch 1, **dadurch gekennzeichnet, daß** Target aus Ferrit besteht.

3. Induktiver Sicherheitssensor nach Anspruch 1 oder 2, **dadurch gekennzeichnet, daß** der Sensor redundant aufgebaut ist, wobei jedes Sensorgehäuse zwei Sensorsysteme aufweist, welche bis auf die positive Versorgungsspannung völlig voneinander getrennt sind und wobei beide Systeme von geringfügig unterschiedlichen Erregerfrequenz erregbar sind.

4. Induktiver Sicherheitssensor nach einem der vorstehenden Ansprüche, **dadurch gekennzeichnet, daß** der Sicherheitssensor einen Schwingkreis (2) zur Sensierung eines Targets (T) aufweist, wobei dem Schwingkreis (2) ein Oszillator (1) vorgeschaltet ist.

5. Induktiver Sicherheitssensor nach einem der vorstehenden Ansprüche, **dadurch gekennzeichnet, daß** der Schwingkreis (2) direkt oder über einen Nullspannungsdetektor (Komparator) (4) an einen ersten Eingang eines Phasenkomparators (3) angeschlossen ist, der einen weiteren Eingang aufweist, welcher mit dem Oszillator (1) verbunden ist.

6. Induktiver Sicherheitssensor nach einem der vorstehenden Ansprüche, **dadurch gekennzeichnet, daß** dem Phasenkomparator (3) ein Integrator (5) und diesem ein Schwellwertschalter (6) nachgeschaltet ist.

7. Induktiver Sicherheitssensor nach einem der vorstehenden Ansprüche, **dadurch gekennzeichnet, daß** dem Schwellwertschalter (6) ein Längsregler (7) nachgeschaltet ist.

8. Induktiver Sicherheitssensor nach einem der vorstehenden Ansprüche, **dadurch gekennzeichnet, daß** der Oszillator (1) zur Erzeugung einer Rechteckspannung ausgelegt ist.

9. Induktiver Sicherheitssensor nach einem der vorstehenden Ansprüche, **dadurch gekennzeichnet, daß** der Phasenkomparator (3) zur Verarbeitung digitaler Signale ausgelegt ist und daß der Nullspannungsdetektor (4) dazu ausgelegt ist, das Ausgangssignal des Schwingkreises (2) in ein Rechtecksignal umzuwandeln.

10. Induktiver Sicherheitssensor nach einem der vorstehenden Ansprüche, **dadurch gekennzeichnet, daß** der Phasenkomparator (3) derart ausgelegt ist, dass er ausschließlich auf negative Phasenwinkel reagiert, die durch Materialien mit einer hohen magnetischen Permeabilität hervorgerufen werden, wobei hinter dem Phasenkomparator (3) ein PWM-Signal entsteht, dessen Puls-Pause-Verhältnis ein Maß für die Veränderung des Ausgangssignals des Schwingkreises (2) ist.

11. Induktiver Sicherheitssensor nach einem der vorstehenden Ansprüche, **dadurch gekennzeichnet, daß** das PWM-Signal über den Integrator (5) in eine dem Puls-Pause-Verhältnis folgende Gleichspannung transformiert und dem Schwellwertschalter (6) zugeführt wird, der so dimensioniert ist, daß nur die Veränderung des Schwingkreises, die durch ein spezielles Material in einem genau definiertem Abstand hervorgerufen wird, zu einem Schalten dieses Schalters führt.

12. Induktiver Sicherheitssensor nach einem der vorstehenden Ansprüche, **dadurch gekennzeichnet, daß** die Resonanzfrequenz des Schwingkreises (2) so ausgelegt ist, dass die Erregerfrequenz auf der abfallenden Flanke der Resonanzkurve liegt.

13. Induktiver Sicherheitssensor, insbesondere nach einem der vorstehenden Ansprüche, **dadurch gekennzeichnet, daß** der Schwingkreis des Sensors Abgleichspulen aufweist, die verstellbar ausgelegt sind.

14. Induktiver Sicherheitssensor nach einem der vorstehenden Ansprüche, **dadurch gekennzeichnet, daß** die Abgleichspulen einen abgeflachten Wickelkörper aufweisen und eine Verstellmechanik zur Verstellung ihrer Lage.

15. Induktiver Sicherheitssensor nach einem der vorstehenden Ansprüche, **dadurch gekennzeichnet, daß** der Wickelkörper (100) in ein Gehäuse (102) eingesetzt ist und über eine Schraube (105) verstellbar ist, gegen die eine Feder (104) wirkt.

16. Induktiver Sicherheitssensor nach einem der vorstehenden Ansprüche, **dadurch gekennzeichnet, daß** der Phasendetektor eine EXOR-Gatter- oder eine D-Flip-Flop- Anordnung aufweist, derart, daß unter der Voraussetzung, dass die Clock-und Data-Eingänge des D-Flip-Flops ständig auf High-Potential liegen, die Wahrheitstabelle wie folgt aussieht:
| | | |
|---|---|---|
| Set | Reset | Q |
| L | L | H |
| L | H | H |
| H | L | L |
| H | H | Kein Wechsel |

17. Induktiver Sicherheitssensor nach einem der vorstehenden Ansprüche, **dadurch gekennzeichnet, daß** mit zwei Komparatoren zusätzlich zum Betriebsstrom, der nahezu konstant ist, zwei weitere Ströme dazugeschaltet sind, so daß ein Strom bei Erreichen des Nennschaltabstands, ein zweiter Strom bei Erreichen eines etwas geringeren Diagnose-Schaltabstandes (yellow-state) dazugeschaltet, wird, wobei der zweite Schaltabstand dazu genutzt wird, um mechanischen Verschleiß der Anlage zu erkennen.
